# EUROPEAN PATENT APPLICATION

(11) **EP 4 617 769 A1**
(43) Date of publication of application: **17.09.2025**
(21) Application number: 25158819.0
(22) Date of filing: 19.02.2025
(51) Int. Cl.: G03B 17/14, G03B 17/55, G03B 17/56

(54) **IMAGE CAPTURING APPARATUS**

(30) Priority: 05.03.2024 JP 2024033087
(71) Applicant: CANON KABUSHIKI KAISHA, Tokyo 146-8501 (JP)
(72) Inventor: MIZUTANI, Shoma, Tokyo, 146-8501 (JP)
(74) Representative: Canon Europe Limited

(57) **Abstract**

An image capturing apparatus (100 Fig 3) according to an aspect of the present invention includes an air circulation conduit 31 that is not communicated with an inside of a housing 30 and is provided between a lens mount portion (10, Fig. 1A) and an image sensor (Fig 3, 50) in an optical axis direction, and a metallic plate (Fig. 3, 60) located on a facing surface of the image sensor.

## Description

### BACKGROUND OF THE INVENTION

### Field of the Invention

The present invention relates in particular to a heat dissipation structure for an image capturing apparatus.

### Description of the Related Art

With the recent advancement in semiconductor technology, image capturing apparatuses have significantly improved in performance. The improvement in the performance of processors and imaging sensors makes it possible to read out a larger number of pixels at a higher speed.

Under such circumstances, one of the issues to be solved is heat generated from semiconductor elements. One of the important technical issues is to more effectively dissipate and release heat to elicit high performance so as to prevent occurrence of a failure due to heat and ensure the safety of every user that touches an electronic device, while exerting the high performance.

Japanese Patent Application Laid-Open Publication No. 2008-098924 discusses an image capturing apparatus having a structure in which a heat-releasing air duct that is not communicated with the inside of the image capturing apparatus is provided between an image sensor and a circuit board as a heat-generating element and a portion located at a side of the image sensor is formed of a material having a thermal conductivity lower than that of a portion located at a side of the circuit board.

According to this structure, an improvement in heat dissipation efficiency can be achieved while an adverse effect of heat transferred to an outer casing to be gripped by a user and an adverse effect of heat generated from the circuit relative to the image sensor can be prevented.

Japanese Patent Application Laid-Open Publication No. 2019-219458 discusses an image capturing apparatus having a structure in which a first housing unit including an opening formed on the back surface thereof is thermally connected to an electronic device while the opening is covered.

The image capturing apparatus further includes a second housing unit including a heat dissipation portion that is opposed to an electronic device, and the heat dissipation portion is not communicated with the inside of the image capturing apparatus and allows inflow of outside air.

### SUMMARY OF THE INVENTION

According to a first aspect of the present invention, there is provided an image capturing apparatus as specified in claim 1. Preferable features are specified in claims 2 to 6.

Further features of the present invention will become apparent from the following description of embodiments with reference to the attached drawings.

### BRIEF DESCRIPTION OF THE DRAWINGS

Figs. 1A to 1C are external perspective views each illustrating an image capturing apparatus according to a first embodiment.
Fig. 2 is a block diagram illustrating an electric configuration of the image capturing apparatus according to the first embodiment.
Fig. 3 is an exploded perspective view of the image capturing apparatus according to the first embodiment.
Fig. 4 illustrates details of an air circulation conduit of the image capturing apparatus according to the first embodiment.
Figs. 5A and 5B are sectional views of the image capturing apparatus according to the first embodiment.
Fig. 6 illustrates details of an air circulation conduit of an image capturing apparatus according to a second embodiment.
Fig. 7 is a schematic view illustrating an image capturing apparatus according to a third embodiment.

### DESCRIPTION OF THE EMBODIMENTS

The conventional structures discussed in Japanese Patent Application Laid-Open Publication Nos. 2008-098924 and 2019-219458 described above are each provided with a heat-releasing air duct in such a manner that the heat-releasing air duct is superimposed on a circuit board, which leads to an increase in the thickness of the image capturing apparatus.

In addition, in the structures described above, the housing is divided into parts, which may lead to deterioration in assembling workability and complexity of internal wiring.

Accordingly, the present invention is directed to providing an interchangeable-lens image capturing apparatus capable of effectively releasing heat from an image sensor while preventing an increase in the size of the image capturing apparatus in an optical axis direction.

Embodiments of the present invention will be described in detail below with reference to the attached drawings. In the embodiments, the same elements are denoted by the same reference numerals.

The embodiments to be described below are examples used in understanding how to implement the present invention. The embodiments described below may be altered or changed as appropriate, within the scope of the invention, depending on the configuration of an apparatus to which the present invention is applied. The present invention is not limited solely to the following embodiments.

One or more of the features or elements of the embodiments to be described below may be combined where appropriate. That is to say each of the embodiment and configurations described throughout can be implemented solely or as a combination of a plurality of embodiments or one or more features therefore where necessary or where the combination of elements or one or more features from individual embodiments in a single embodiment are beneficial.

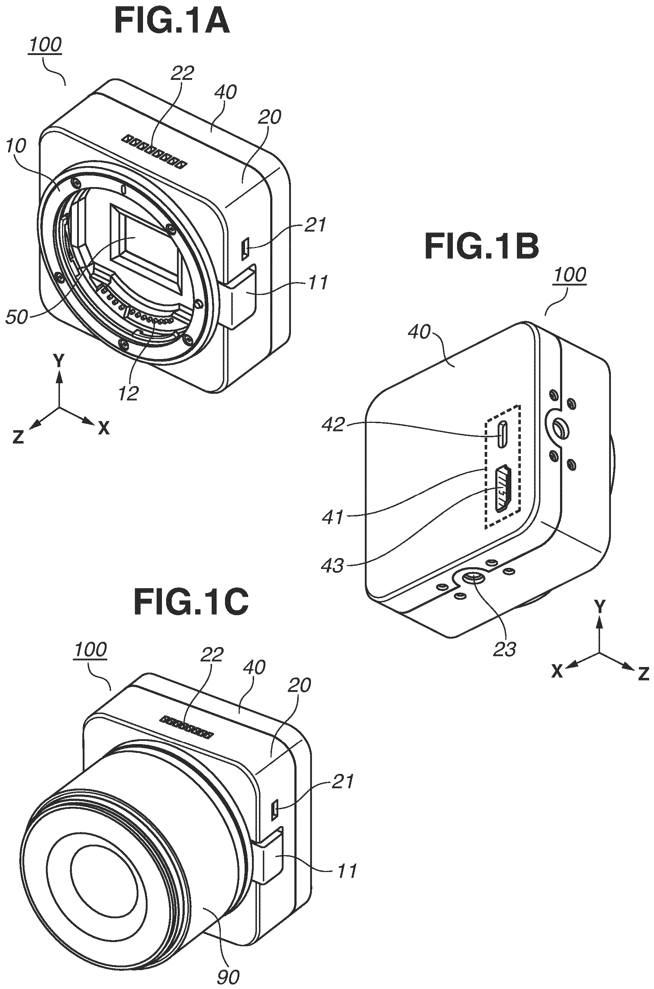

First, a basic configuration of an image capturing apparatus 100 according to a first embodiment of the present invention will be described with reference to Figs. 1A to 1C. Fig. 1A is an external perspective view of the image capturing apparatus 100 as viewed from the front surface thereof. Fig. 1B is an external perspective view of the image capturing apparatus 100 as viewed from the back surface thereof. Fig. 1C is an external perspective view illustrating a state where an interchangeable lens 90 is attached to the image capturing apparatus 100.

### (Basic Configuration of Image Capturing Apparatus 100)

It is assumed that the image capturing apparatus 100 is an interchangeable-lens camera for video streaming and is used in a state where the image capturing apparatus 100 is fixed to a tripod or a support. However, the image capturing apparatus may be any other image capturing apparatus with or without an interchangeable-lens, i.e., an image capturing apparatus with a built-in or non-interchangeable lens, which can be used for image capture, video capture, video stream or the like.

The image capturing apparatus 100 does not include recording media. The image capturing apparatus 100 transmits image capturing data to a personal computer (PC), and the PC performs streaming and recording processing. The image capturing apparatus 100 does not include batteries, and thus is driven by power fed through a connected wire.

The image capturing apparatus 100 includes a lens mount 10 for mounting an image sensor 50 and the interchangeable lens 90, and lens communication terminals 12 for communicating with the interchangeable lens 90 are provided in the lens mount 10.

The image sensor 50 includes a mounting board on which the image sensor is mounted. That is to say, the image sensor 50 may be considered to comprise a mounting board and a sensor for imagining, i.e. the image sensor, mounted to the mounting board. An optical filter and the like are formed on an object side of an imaging plane of the image sensor mounted on the mounting board.

An optical axis is parallel to a Z-axis direction, and light that has transmitted through the interchangeable lens 90 forms an image on the image sensor 50, i.e. the image sensor mounted to the mounting board, thereby making it possible to capture images and moving images.

The image capturing apparatus 100 includes a front-side exterior 20 and a back-surface exterior 40 as external components. The front-side and read-side exteriors may be enclosures components. A lens unlock button 11 is provided on a side surface of the image capturing apparatus 100.

When the lens unlock button 11 is allowed to slide to a negative side in the Z-axis direction, the lens mount 10 is unlocked, so that the interchangeable lens 90 can be mounted or dismounted. Other embodiments may use other means or the same means moving in different directions to release the interchangeable-lens.

Each of a first tripod mount 23 and a second tripod mount 24 is provided on a surface different from the surface on which the lens unlock button 11 is provided. Other embodiments may be provided with one or more than one tripod mount, and the location of the one or more than one tripod mount may be different to that described in the first embodiment.

General tripods or camera fixation accessories can be mounted on the first tripod mount 23 and the second tripod mount 24 by screwing.

If the first tripod mount 23 is fixed at a position corresponding to the lower surface of the image capturing apparatus 100, the image capturing apparatus 100 can capture a video image in which the long side of the image sensor 50 is horizontal, thereby making it possible to capture a video image suitable for viewing on the landscape-oriented lower surface of a display of a PC or the like.

If the second tripod mount 24 is fixed at a position corresponding to the lower surface of the image capturing apparatus 100, the image capturing apparatus 100 can capture a video image in which the long side of the image sensor 50 is vertical, thereby making it possible to capture a video image suitable for viewing on a portrait-oriented screen of a smartphone or the like.

The provision of the first tripod mount 23 and the second tripod mount 24 on the two surfaces enables the image capturing apparatus 100 to cover various fixation methods and image capturing directions.

The back surface of the image capturing apparatus 100 is provided with a communication terminal unit 41 used to establish communication and feed power.

The communication terminal unit 41 includes a universal serial bus (USB) terminal 42 and a high-definition multimedia interface (HDMI) terminal 43. The communication terminal unit 41 connects the image capturing apparatus 100 to a switcher of a PC or a camera, a recording device, or the like using various cables, thereby enabling the image capturing apparatus 100 to be used as a web camera or a camera for video streaming.

The USB terminal 42 also functions as a power feeding terminal and is connected to an alternating-current (AC) adaptor or a mobile battery to supply power for driving the image capturing apparatus 100.

Depending on the specifications of a connection destination, only one cable may be used to establish communication and feed power. The USB terminal 42 and the HDMI terminal 43 are merely examples of embodiments. For example, any other communication terminal such as a serial digital interface (SDI) may be used.

The image capturing apparatus 100 is not provided with a power switch, and starts output of a video image at the start of power feeding.

A first intake and exhaust port 21 and a second intake and exhaust port 22 are provided on two respective surfaces on which the first tripod mount 23 and the second tripod mount 24 are not provided. The first intake and exhaust port may be referred to as a first cooling port. The second intake and exhaust port may be referred to as a second cooling port. The ports 21, 22 are airflow ports or means that allow for air to be taken in or exhaust out from the image capturing apparatus. The ports 21, 22 may also be considered heat release ports or heat release means.

The first intake and exhaust port 21 and the second intake and exhaust port 22 are intake and exhaust ports that are mainly used to release heat generated from the image sensor 50. The first intake and exhaust port 21 and the second intake and exhaust port 22 will be described in detail below.

The provision of the first intake and exhaust port 21 and the second intake and exhaust port 22 on the two surfaces different from the surfaces on which the tripod mounts are provided reduces the risk of closing the intake and exhaust ports even when the image capturing apparatus 100 is fixed to a tripod (not illustrated). Preferably, the ports may be disposed on surfaces opposite the surface to which the mounting means are disposed.

The structure in which one of the first intake and exhaust port 21 and the second intake and exhaust port 22 is located at the position corresponding to the upper surface even when one of the first tripod mount 23 and the second tripod mount 24 is fixed at the position corresponding to the lower surface facilitates release of an upward air current due to generated heat.

### (Block Diagram)

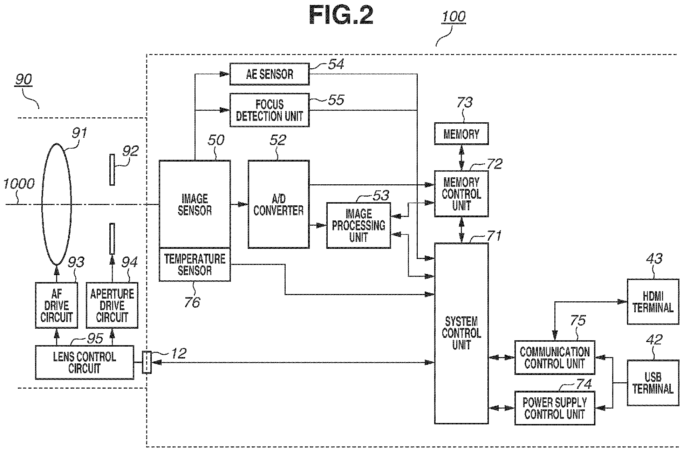

Next, an electric configuration and operation of the image capturing apparatus 100 according to an embodiment of the present invention will be described with reference to Fig. 2. Fig. 2 illustrates a block diagram of the image capturing apparatus 100 and also illustrates a main electric configuration of the image capturing apparatus 100 as a schematic view.

An optical lens unit 91 is incorporated in the interchangeable lens 90. Although schematically illustrated in Fig. 2, in practice, the optical lens unit 91 is a lens unit including a plurality of lenses.

An autofocus (AF) drive circuit 93 causes some of the lenses in the optical lens unit 91 to advance or recede to thereby perform a focus adjustment.

An electromagnetic diaphragm 92 for adjusting the amount of light is located on an optical axis 1000 of the optical lens unit 91.

An opening diameter of the electromagnetic diaphragm 92 can be changed by an aperture drive circuit 94 based on a designated aperture value.

The interchangeable lens 90 and the image capturing apparatus 100 are electrically connected via the lens communication terminals 12. Based on communication with the image capturing apparatus 100, a lens control circuit 95 controls the AF drive circuit 93 and the aperture drive circuit 94 to drive the interchangeable lens 90 according to a desired setting.

A system control unit 71 performs a main operation control operation for the image capturing apparatus 100.

The system control unit 71 is a small micro processing unit (MPU) mounted on a control board 70, and components of the system control unit 71 are electrically connected.

A light beam that has transmitted through the interchangeable lens 90 forms an image on the image sensor 50, and an analog-to-digital (A/D) converter 52 extracts the output of the image sensor 50 as a digital signal.

After that, an image processing unit 53 performs processing such as filter processing and data compression processing on the digital signal, and transmits the digital signal to the system control unit 71.

The memory control unit 72 may store image capturing results in a memory 73 depending on image processing or specifications for communication with an external device.

The image sensor 50 also functions as an automatic exposure (AE) sensor 54 and a focus detection unit 55.

For example, the AE sensor 54 calculates exposure information based on image capturing results, and the system control unit 71 that has received the exposure information performs processing for adjusting the aperture value of the interchangeable lens 90, the International Organization for Standardization (ISO) sensitivity of the image sensor 50, a shutter speed, and the like so as to obtain a desired exposure.

The focus detection unit 55 has a function for calculating a driving direction and a movement amount of a focus lens based on a defocus state of an image formed on the image sensor 50 and feeding back calculation results to the AF drive circuit 93 of the interchangeable lens 90, thereby making it possible to rapidly focus on an object.

A communication control unit 75 is connected to the USB terminal 42 and the HDMI terminal 43 to perform communication processing with an external device.

A connection to a PC or a tablet terminal makes it possible to output a captured video image and perform video image recording and streaming.

An input from an external device makes it possible to make image capturing settings for the image capturing apparatus 100. The USB terminal 42 is also connected to a power supply control unit 74, and can also be used as a terminal that receives power suppled from an AC adaptor of a USB output or the like.

The image sensor 50 is provided with a temperature sensor 76. The temperature sensor 76 sends temperature information to the system control unit 71 to thereby monitor the heat generated from the image sensor 50.

To avoid a failure due to high temperature, an image recording process can be interrupted when a predetermined threshold is reached.

### (Internal Configuration of Image Capturing Apparatus 100)

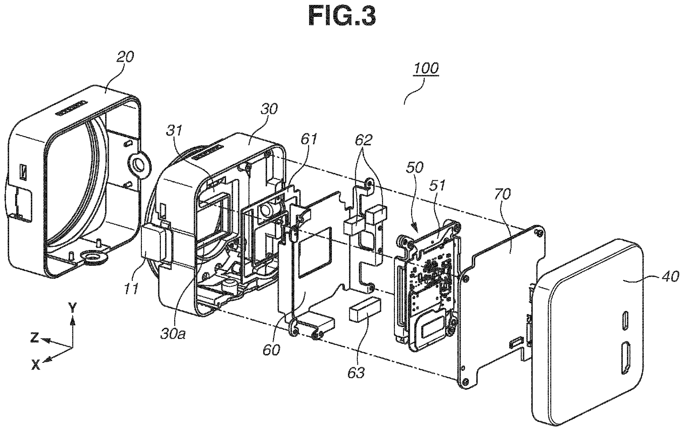

Next, an internal configuration of the image capturing apparatus 100 according to an embodiment of the present invention will be described with reference to Fig. 3. Fig. 3 is an exploded perspective view of the image capturing apparatus 100 as viewed along the Z-axis direction.

An internal housing 30 is provided on the inside of the front-side exterior 20.

The internal housing 30 functions as a main frame, and is assembled with various components, the image sensor 50, the exterior including the front-side exterior 20, and the like.

The internal housing 30 is also provided with a rectangular opening 30a that is provided in an area other than an image capturing range so as to prevent the light beam from the interchangeable lens 90 from being blocked. That is to say, the opening 30a disposed such that it does not interfere with the functioning of the camera, i.e. it does not interfere with the light beam from the interchangeable-lens from being received by the image sensor. Put another way, the opening is provided in the housing such that when fitted the image sensor is not obstructed by the housing, e.g. when the image sensor is fitted it is wholly visible in a plan view through the opening.

The internal housing 30 is also provided with an air circulation conduit 31 to be described in detail below. A heat transfer metallic plate 60 is provided on a surface facing the air circulation conduit 31.

A rubber seal 61 is sandwiched between the heat transfer metallic plate 60 and the air circulation conduit 31, so that the opening of the air circulation conduit 31 is hermetically sealed with the heat transfer metallic plate 60.

In other words, the air circulation conduit 31 is separated from the internal space of the image capturing apparatus 100 and is not communicated with the internal space of the image capturing apparatus 100. This prevents entry of dust or the like and adhesion of dust or the like to the image sensor 50 and the control board 70.

A metallic material having higher thermal conductivity, such as an aluminum alloy or copper can be used as a material for the heat transfer metallic plate 60.

The image sensor 50 is fixed to a retaining plate 51 and is opposed to the heat transfer metallic plate 60.

A first elastic heat transfer member 62 and a second elastic heat transfer member 63 are sandwiched between the retaining plate 51 and the heat transfer metallic plate 60, thereby making it possible to release the heat generated from the image sensor 50 to the heat transfer metallic plate 60.

The first elastic heat transfer member 62 and the second elastic heat transfer member 63 are located at upper and lower positions, respectively, of the image sensor 50 in a Y-axis direction, thereby preventing the temperature of the image sensor 50 from being locally decreased and preventing a temperature distribution from being biased.

The control board 70 is located on the back surface of the image sensor 50 and is electrically connected to the image sensor 50 and the lens communication terminals 12 via a flexible printed board and connectors.

Various communication terminals of the communication terminal unit 41 are mounted on the control board 70.

The control board 70 performs an overall control operation for driving the image capturing apparatus 100, such as a control operation for the image sensor 50, a control operation for communication with the interchangeable lens 90, and a control operation for communication with an external device.

The control board 70 is screwed to the internal housing 30 through the heat transfer metallic plate 60, and four corners of the control board 70 contact the heat transfer metallic plate 60, thereby making it possible to release the heat generated from the control board 70 to the heat transfer metallic plate 60. Put another way, the control board to secured to the internal housing through fixation means, preferably screws, which in use extend through the heat transfer metallic plate 60. The four corners, or a plurality discrete locations around the periphery, of the control board are in contact with the heat transfer metallic plate to allow heat generated from the control board to be transferred to the heat transfer metallic plate.

### (Air Circulation Conduit 31)

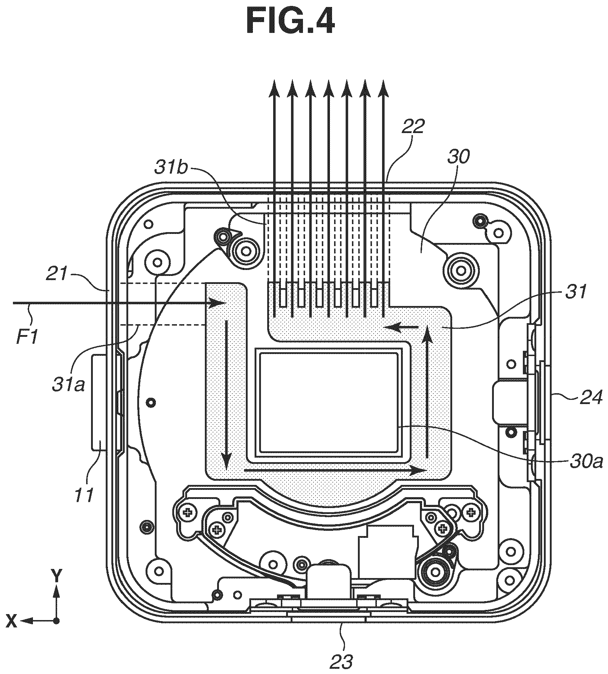

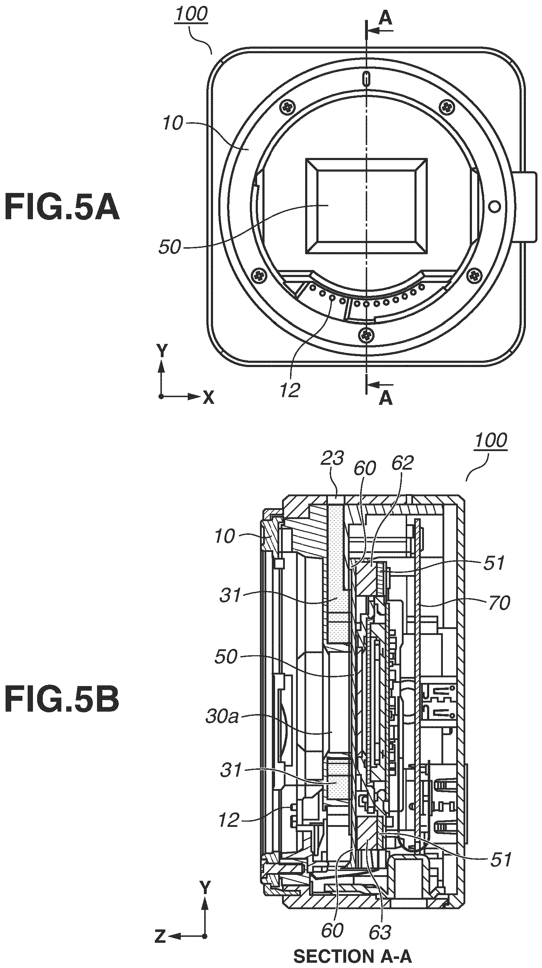

Next, the air circulation conduit 31 of the image capturing apparatus 100 according to an embodiment of the present invention will be described in detail with reference to Fig. 4 and Figs. 5A and 5B.

Fig. 4 illustrates the internal housing 30 as viewed from the back surface side in a state where the air circulation conduit 31, except for the heat transfer metallic plate 60, the image sensor 50, the control board 70, and the like, is exposed. Fig. 5A is a front view of the image capturing apparatus 100. Fig. 5B is a sectional view of the image capturing apparatus 100 taken along a line A-A illustrated in Fig. 5A.

A first intake and exhaust path 31a is a tunnel-like flow path provided in the internal housing 30 and leads to the first intake and exhaust port 21 provided above the lens unlock button 11 on the side surface.

Similarly, a second intake and exhaust path 31b is a tunnel-like flow path provided in the internal housing 30 and leads to the second intake and exhaust port 22 provided on the upper surface. In other embodiments, the intake and exhaust ports may be disposed in any surface, and the air circulation conduit extends between both ports.

The path leading from one or each intake and exhaust port may branch off into a plurality of paths, like the second intake and exhaust path 31b.

The air circulation conduit 31 is located to surround the four surrounding sides of the opening 30a. For example, air flowing in from the first intake and exhaust port 21 is allowed to pass through a path as indicated by an arrow F1 and can be exhausted through the second intake and exhaust port 22. Put another the air circulation conduit 31 is disposed to substantially surround the four sides of the opening 30a, i.e. the air circulation conduit 31 extends substantially along each side of the opening.

A hatched area in the air circulation conduit 31 illustrated in Fig. 4 is opened to the back surface side, and as described above with reference to Fig. 3, the opening is hermetically sealed with the rubber seal 61 and the heat transfer metallic plate 60.

In other words, as illustrated in Fig. 5B, a part of the surface of the air circulation conduit 31 is formed of the heat transfer metallic plate 60.

With the above-described configuration, heat generated in the camera is collected on the heat transfer metallic plate 60, and the heat transfer metallic plate 60 is also exposed to the internal surface of the air circulation conduit 31, thereby making it possible to effectively release the heat.

The air circulation conduit 31 is located around the opening 30a, so that the effect of uniformly releasing heat generated from the image sensor 50 is obtained.

According to the related art, in interchangeable-lens cameras, such as the image capturing apparatus 100, the optical path length from the lens mount 10 to the image sensor 50 is uniquely standardized, so that various interchangeable lenses can be used.

Many cameras that emphasize still image capturing incorporate a mechanical shutter mechanism mounted in a space between the lens mount 10 and the image sensor 50, and the optical path length is set also in consideration of the space.

However, in general, such a mechanical shutter mechanism is not used in moving image capturing. Therefore, like in the image capturing apparatus 100 according to the present embodiment, the necessity of the shutter mechanism for a camera that mainly uses moving image capturing functions is low.

On the other hand, the image sensor 50 is always operated in a recording state during moving image capturing. Thus, in particular, heat generated from the image sensor 50 is a significant issue.

That is, according to the present embodiment, it is possible to provide a structure for effectively releasing heat generated from the image sensor 50 while preventing an increase in the size of the image capturing apparatus 100 by utilizing the space for the shutter mechanism that is not required for a moving image capturing apparatus.

The features of the first embodiment will be described below with reference to the drawings and the reference numerals.

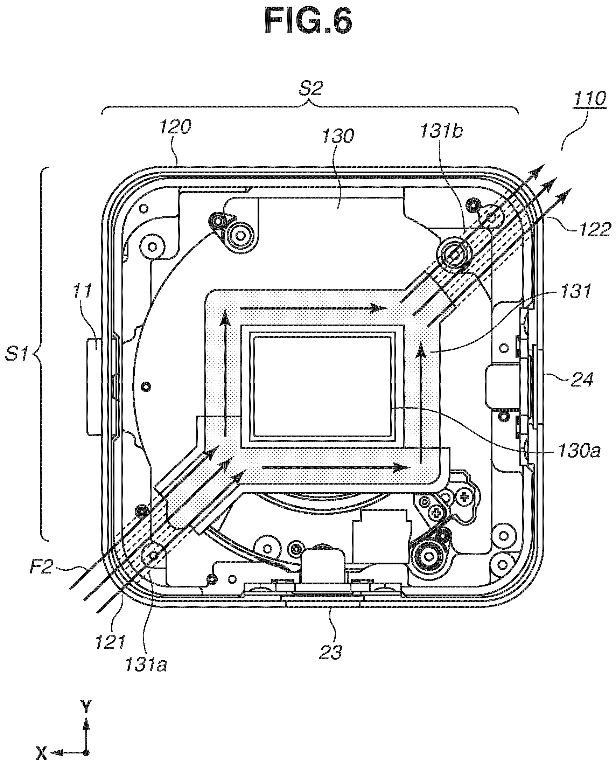

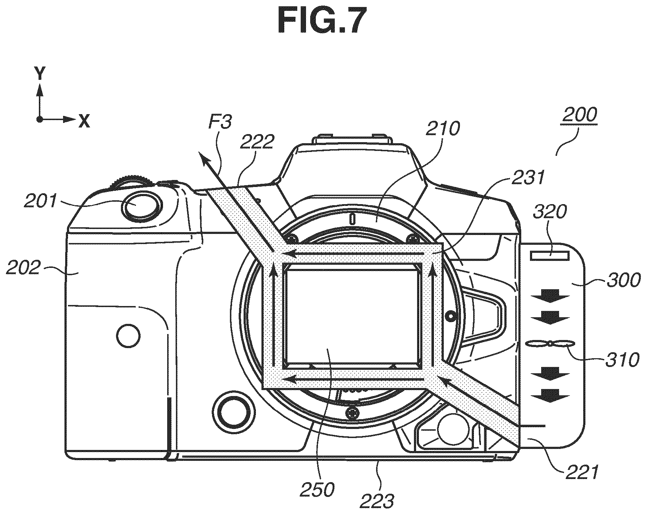

A first set of features are now described with reference to Fig. 4 (also shown in Figs. 6 and 7).

The image capturing apparatus 100 includes the image sensor 50, the lens mount 10 to which an interchangeable image capturing lens is mountable, the housing 30 including the opening 30a functioning as an optical path during image capturing, and the metallic plate 60 formed on the image plane side relative to the housing 30.

The image capturing apparatus 100 further includes the air circulation conduit 31 that is formed of the housing 30 and the metallic plate 60, includes intake and exhaust ports, and is not communicated with, i.e. in communication with, the inside of the housing 30.

The air circulation conduit 31 is provided between the lens mount 10 and the image sensor 50 in the optical axis direction, and the metallic plate 60 is located on the facing surface of the image sensor 50.

Next, a second, preferable, feature is described with reference to Fig. 4.

The metallic plate 60 is thermally connected to the image sensor 50.

Next, a third, preferable, feature is described with reference to Fig. 4.

The housing 30 includes the tripod screw hole portions (the first tripod mount 23 and the second tripod mount 24) that are configured to fix the housing 30 to a tripod, and the first intake and exhaust port 21 and the second intake and exhaust port 22 of the air circulation conduit 31 are provided on the surfaces on which the tripod screw hole portions (the first tripod mount 23 and the second tripod mount 24) are not present.

Next, a fourth, preferable, feature is described with reference to Fig. 4 (also disclosed in Figs. 6 and 7).

The opening 30a and an opening 130a each have a rectangular shape. The air circulation conduit 31 is provided along the four sides of the openings 30a, and an air circulation conduit 131 is provided along the four sides of the opening 130a.

The first embodiment described above illustrates an example where, in the image capturing apparatus 100 for video streaming, the air circulation conduit 31 is located around the opening 30a in the internal housing 30 and leads from the first intake and exhaust port 21 provided on the side surface to the second intake and exhaust port 22 provided on the upper surface.

A second embodiment illustrates an example where intake and exhaust ports are arranged in a different manner and the flow path branches off.

A basic configuration of an image capturing apparatus according to the second embodiment is similar to that of the first embodiment, and thus detailed description with reference to the same reference numerals is omitted.

### (Internal Housing 130 of Image Capturing Apparatus 110)

Fig. 6 illustrates an internal housing 130 of an image capturing apparatus 110 according to the second embodiment as viewed from the back surface thereof.

Like in the first embodiment, the image capturing apparatus 110 has a substantially square external shape about the optical axis, and the four corner portions of the image capturing apparatus 110 have an arc shape. In other embodiments, one or more corners may have an arc or chamfered shape.

Like in the first embodiment, the image capturing apparatus 110 includes the first tripod mount 23 provided on the lower surface and the second tripod mount 24 provided on the side surface. This configuration enables the image capturing apparatus 110 to cover various fixation directions and image capturing directions. Similar to the first embodiment, the number and location of tripod mounts may alter in different embodiments.

The internal housing 130 includes the opening 130a that is located in an area other than the image capturing range, like in the first embodiment, and the air circulation conduit 131 that is located around the opening 130a. That is to say, the opening 30a disposed such that it does not interfere with the functioning of the camera, i.e. it does not interfere with the light beam from the interchangeable-lens from being received by the image sensor. Put another way, the opening is provided in the housing such that when fitted the image sensor is not obstructed by the housing, e.g. when the image sensor is fitted it is wholly visible in a plan view through the opening.

The air circulation conduit 131 is provided with a first intake and exhaust path 131a having a tunnel shape leading to a first intake and exhaust port 121 provided on a front-side exterior 120, and a second intake and exhaust path 131b having a tunnel shape leading to a second intake and exhaust port 122. That is to say that the first and second intake and exhaust paths 131a, 131b may be a bore, or multiple bores, having a cross-sectional shape along the or each bore.

In the second embodiment, the first intake and exhaust port 121 is provided at a location near a corner portion of the image capturing apparatus 110. That is to say that the port may be disposed near or on a corner portion of the image capturing apparatus.

For example, if air flows in from the first intake and exhaust port 121, as indicated by an arrow F2, the air passes through the first intake and exhaust path 131a and is led to the air circulation conduit 131 located around the opening 130a.

The air circulation conduit 131 branches off along each side at each corner portion of the opening 130a having a rectangular shape, and merges again at an opposing corner. That is to say, the air circulation conduit may branch off at two corner portions of the opening 130a. The air circulation conduit at the two other corners, i.e. not the branching off corners, may provide a corner in the circulation conduit.

The air passes through the second intake and exhaust path 131b and is then exhausted through the second intake and exhaust port 122 provided at the opposing corner of the first intake and exhaust port 121. That is to say that the second port may be disposed near or on a corner portion of the image capturing apparatus, preferably the second port is disposed near or on a corner portion of the image capturing apparatus different to corner portion to which the first port is disposed, more preferably the second port is disposed to an opposing corner, even more preferably, the second port is disposed to a diametrically opposed corner.

The air circulation conduit 131 according to the second embodiment can be located around the opening 130a, and the number of portions where the flow path is curved can be reduced as compared with the configuration according to the first embodiment.

In other words, the configuration according to the second embodiment enables air to pass with lower resistance, so that it can be expected that heat can be more effectively released by convection heat transfer.

Further, the formation of the first intake and exhaust port 121 having an arc shape in the vicinity of the corner portion of the image capturing apparatus 110 makes it possible to prevent the first intake and exhaust port 121 from being entirely closed even when a tripod having a width greater than the bottom surface of the image capturing apparatus 110 is mounted on the first tripod mount 23. That is to say the first and/or second port may extend along the arcuate corner, i.e. chamfered corner, of image capturing apparatus, i.e. the port may extend along the surface of the arc of the corner. The same advantage applies to the second intake and exhaust port 122.

Similarly, the second intake and exhaust port 122 can be prevented from being closed when the tripod is fixed to the second tripod mount 24. The same can be said for the first intake and exhaust port 121.

In addition, unlike in the first embodiment, the first intake and exhaust port 121 and the second intake and exhaust port 122 are each located in the vicinity of the corner portion, so that a side surface S1 and a side surface S2 can be widely utilized. For example, an advantageous effect that an operation member and a display member can be easily arranged in an area other than the intake and exhaust ports can be obtained.

Features of the second embodiment will be described briefly below with reference to the drawings and the reference numerals.

Next, a fifth, preferable, feature is described with reference to Fig. 6.

The image capturing apparatus 110 has a rectangular shape as viewed along the optical axis direction, and each corner portion of the image capturing apparatus 110 has a chamfered shape or an arc shape. The first intake and exhaust port 121 and the second intake and exhaust port 122 of the air circulation conduit 131 are each provided at a corner portion.

Next, a sixth, preferable, feature is described with reference to Fig. 6 (also disclosed in Fig. 7).

The air circulation conduit 131 branches off into two directions at a corner portion of the opening 130a. That is to say a branch-off portion of the air circulation conduit 131 may be provided at each of two corners.

The first and second embodiments described above illustrate an example where the present invention is applied to an image capturing apparatus for video streaming. In a third embodiment, an example where the present invention is applied to an image capturing apparatus of a typical type that captures an image in a state where a user grips the image capturing apparatus will be described with reference to a schematic view.

Fig. 7 is a schematic view of an image capturing apparatus 200 according to the third embodiment as viewed from the front surface thereof.

Like in the first and second embodiments, the image capturing apparatus 200 includes an image sensor 250, a lens mount 210 for mounting an interchangeable lens (not illustrated), and a tripod mount 223 for mounting a tripod.

The image capturing apparatus 200 also includes a shutter button 201 for the user to issue an image capturing start instruction, and a grip portion 202 for the user to grip the image capturing apparatus 200.

An air circulation conduit 231 indicates an image of an air circulation conduit illustrated in a manner superimposed on the image capturing apparatus 200.

In practice, like in the first and second embodiments, the air circulation conduit 231 is provided between the lens mount 210 and an image sensor 250, and a part of the surface of the air circulation conduit 231 is formed of a metallic plate (not illustrated) that is thermally connected to the image sensor 250. The air circulation conduit 231 is not communicated with the inside of the image capturing apparatus 200.

A first intake and exhaust port 221 that leads to the air circulation conduit 231 is provided in the vicinity of a corner portion of a side surface on a side opposite to the grip portion 202.

The first intake and exhaust port 221 can be prevented from being closed even in a state where a tripod is used or the user is gripping the image capturing apparatus 200. Further, the second intake and exhaust port 222 is provided on the upper surface of the image capturing apparatus 200 and on a side more inward than the shutter button 201 so as to prevent the second intake and exhaust port 222 from being closed and prevent exhausted air from blowing to the operation member and the user's hand.

In the third embodiment, an air-cooling fan accessory 300 is attached to a side surface of the image capturing apparatus 200. The air-cooling fan accessory 300 includes an air-cooling fan 310 and an intake port 320 so that the air can be actively guided into the first intake and exhaust port 221 by power fed from the image capturing apparatus 200. A built-in fan or fan accessory may be an optional additional to the first and/or section embodiments.

In particular, in an image capturing mode or the like in which a large amount of heat is generated from the image sensor 250, the air circulation conduit 231 can be utilized in combination with an external accessory such as the air-cooling fan accessory 300.

Embodiments of the present invention have been described above. However, the present invention is not limited solely to the embodiments and can be modified or altered in various manners within the scope of the invention. Each of the embodiment and configurations described throughout the disclosure can be implemented solely or as a combination of a plurality of embodiments or one or more features therefore where necessary or where the combination of elements or one or more features from individual embodiments in a single embodiment are beneficial.

Accordingly, the configurations according to the embodiments included in the present invention are described below.

### (Configuration 1)

An image capturing apparatus 100 including an image sensor 50, a lens mount 10 to which an interchangeable image capturing lens is mountable, a housing 30 including an opening 30a functioning as an optical path during image capturing, a metallic plate 60 formed on an imaging plane side relative to the housing 30, and an air circulation conduit 31 that is formed of the housing 30 and the metallic plate 60, includes intake and exhaust ports, and is not communicated with an inside of the housing 30, in which the air circulation conduit 31 is provided between the lens mount 10 and the image sensor 50 in an optical axis direction, and the metallic plate 60 is located on a facing surface of the image sensor 50.

### (Configuration 2)

The image capturing apparatus according to Configuration 1, in which the metallic plate 60 is thermally connected to the image sensor 50.

### (Configuration 3)

The image capturing apparatus according to Configuration 1 or 2, in which the housing 30 includes a tripod screw hole portion 23 and a tripod screw hole portion 24 that are configured to fix the housing 30 to a tripod, and the intake and exhaust port 21 and the intake and exhaust port 22 of the air circulation conduit 31 are provided on surfaces on which the tripod screw hole portion 23 and the tripod screw hole portion 24 are not present.

### (Configuration 4)

The image capturing apparatus according to any one of Configurations 1 to 3, in which the image capturing apparatus 110 has a rectangular shape as viewed along an optical axis direction, each corner portion of the image capturing apparatus 110 has a chamfered shape or an arc shape, and the intake and exhaust port 121 and the intake and exhaust port 122 of the air circulation conduit 131 are each provided at a corner portion.

### (Configuration 5)

The image capturing apparatus according to any one of Configurations 1 to 4, in which the openings 30a and 130a each have a rectangular shape, the air circulation conduit 31 is provided along four sides of the opening 30a, and the air circulation conduit 131 is provided along four sides of the opening 130a.

### (Configuration 6)

The image capturing apparatus according to any one of Configurations 1 to 5, in which the air circulation conduit 131 branches off into two directions at a corner portion of the opening 130a.

According to the configurations of the embodiments described above, it is possible to provide an interchangeable-lens image capturing apparatus capable of effectively releasing heat from the image sensor while preventing an increase in the size in the optical axis direction.

While the present invention has been described with reference to embodiments, it is to be understood that the invention is not limited to the disclosed embodiments. The scope of the following claims is to be accorded the broadest interpretation so as to encompass all such modifications and equivalent structures and functions.

## Claims

1. An image capturing apparatus (100, 110, 200) comprising:
an image sensor (50, 250);
a lens mount portion (10, 210) to which an interchangeable image capturing lens (90) is mountable;
a housing (30, 130) including an opening (30a) functioning as an optical path during image capturing;
a metallic plate (60) formed on an imaging plane side relative to the housing; and
an air circulation conduit (31, 131, 231) formed of the housing and the metallic plate and including an intake and exhaust port (21, 22, 121, 122, 221, 222), the air circulation conduit being not communicated with an inside of the housing,
wherein the air circulation conduit is provided between the lens mount portion and the image sensor in an optical axis direction, and the metallic plate is located on a facing surface of the image sensor.

2. The image capturing apparatus (100, 110, 200) according to claim 1, wherein the metallic plate (60) is thermally connected to the image sensor (50, 250).

3. The image capturing apparatus (100, 110, 200) according to claim 1 or 2, wherein the housing (30, 130) includes a tripod screw hole portion (23, 223) configured to fix the housing to a tripod, and the intake and exhaust port (21, 22, 121, 122, 221, 222) of the air circulation conduit (31, 131, 231) is provided on a surface of the housing on which the tripod screw hole portion is not present.

4. The image capturing apparatus (100, 110, 200) according to any one of claims 1 to 3, wherein the image capturing apparatus has a rectangular shape as viewed along an optical axis direction, and a corner portion of the image capturing apparatus has one of a chamfered shape and an arc shape and is provided with the intake and exhaust port (21, 22, 121, 122, 221, 222) of the air circulation conduit (31, 131, 231).

5. The image capturing apparatus (100, 110, 200) according to any one of claims 1 to 4, wherein the opening (30a) has a rectangular shape and the air circulation conduit (31, 131, 231) is provided along four sides of the opening.

6. The image capturing apparatus (100, 110, 200) according to any one of claims 1 to 5, wherein the air circulation conduit (31, 131, 231) branches off into two directions at a corner portion of the opening (30a).
